# EUROPÄISCHE PATENTSCHRIFT

(11) **EP 0 309 042 B1**
(45) Veröffentlichungstag und Bekanntmachung des Hinweises auf die Patenterteilung: **16.06.1993**
(21) Anmeldenummer: 88202009.2
(22) Anmeldetag: 15.09.1988
(51) Int. Cl.: H03H 9/10

(54) **Schwingquarzgehäuse für Oberflächenmontage**
Quartz vibrator enclosure for surface mounting
Einceinte pour résonateur à quartz pour montage superficiel

(30) Priorität: 22.09.1987 DE 3731785
(43) Veröffentlichungstag der Anmeldung: 29.03.1989
(73) Patentinhaber: Philips Patentverwaltung GmbH, 22335 Hamburg (DE); Philips Electronics N.V., 5621 BA Eindhoven (NL)
(72) Erfinder: Fick, Franz, Dipl.-Ing., D-2100 Hamburg 90 (DE)
(74) Vertreter: Kupfermann, Fritz-Joachim, Dipl.-Ing.

(56) Entgegenhaltungen:
- EP-A- 0 204 379
- GB-A- 1 537 012
- JOURNAL OF ELECTRONIC ENGINEERING (JEE), Band 24, Nr. 246, Juni 1987, Seiten 61-65, Tokyo, JP; K. HINO: "Chip technology for crystal units and oscillators"

## Beschreibung

Die Erfindung betrifft ein hermetisch verschlossenes, schachtel- oder dosenförmiges Schwingquarzgehäuse mit für Oberflächenmontage (SMD) geeigneten Anschlußleitern aus zwei miteinander verbindbaren Gehäuseteilen bei dem Anschlußleiter isoliert durch ein Gehäuseteil hindurchgeführt und mindestens ein weiterer Anschlußleiter mit dem Gehäuseteil verbunden ist.

Ein Gehäuse dieser Art ist aus dem Datenbuch 1986 der Firma Telequarz, Seite 8 bekannt.

Bei den bekannten Gehäusen verläuft der die beiden Gehäuseteile verbindende Schweißrand senkrecht zur Montagefläche (Printplatte), was die Montage erschwert und einen größeren Abstand zwischen Gehäuse und Printplatte erforderlich macht.

Der Erfindung liegt die Aufgabe zugrunde, diesen Nachteil zu beseitigen und dabei das Gehäuse so auszubilden, daß an dem bereits mit den Anschlußleitern verbundenen Schwingquarz noch Manipulationen vorgenommen werden können, wenn der Anschlußleiter tragende Teil des Gehäuses bereits montiert und kontaktiert ist.

Diese Aufgabe wird erfindungsgemäß dadurch gelöst, daß das Gehäuse in einer gegenüber seiner Grundfläche geneigten Ebene in einen oberen und einen unteren, miteinander verbindbaren Gehäuseteil geteilt ist, daß die Anschlußleitern des Bauelementes an einer Seite isoliert durch das untere Gehäuseteil geführt sind, mit dem an der gegenüberliegenden Seite mindestens ein weiterer Anschlußleiter verbunden ist, und daß der Schwingquarz in dem unteren Gehäuseteil montiert ist.

Weitere Ausgestaltungen der Erfindung ergeben sich aus den Unteransprüchen.

Ein erfindungsgemäßes Schwingquarzgehäuse zeichnet sich dadurch aus, daß seine Montage auf der Printplatte durch die Verbindung der Gehäuseteile nicht beeinflußt wird und daß das Gehäuse so ausgebildet ist, daß es erforderlichenfalls erst verschlossen zu werden braucht, wenn der untere Gehäuseteil mit dem Schwingquarz bereits voll funktionsfähig auf der Printplatte montiert ist.

Ein Ausführungsbeispiel der Erfindung wird im folgenden anhand der beigefügten Zeichnungen näher erläutert.
Es zeigen:

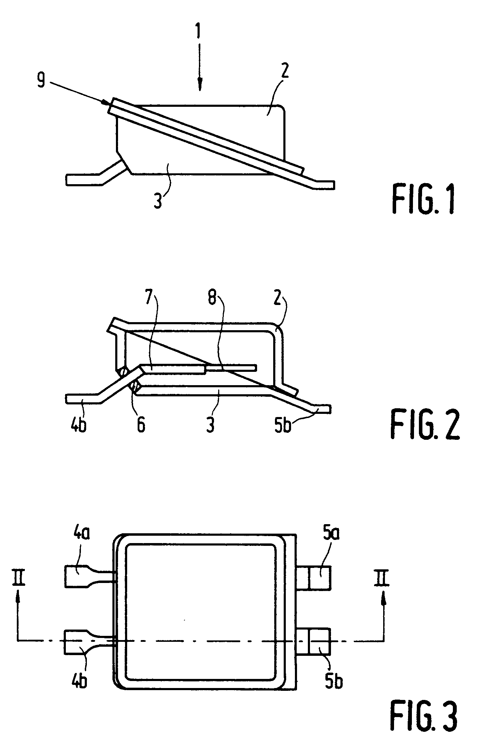

- Fig. 1: ein Schwingquarzgehäuse nach der Erfindung,
- Fig. 2: einen senkrechten Schnitt durch das Gehäuse nach Figur 1,
- Fig. 3: eine Draufsicht auf das Gehäuse nach Figur 1.

Das in der Figur dargestellte schachtelförmige Gehäuse 1 ist durch eine gegenüber seiner Grundfläche geneigte Ebene in zwei Teile 2 und 3 geteilt, die in dieser Ebene, in der sie einen Flansch bilden, im Endzustand miteinander verschweißt oder auf andere Weise fest miteinander verbunden sind. Die Ebene verläuft vorzugsweise diagonal im Gehäuse, d.h. von seiner linken oberen Kante zu seiner rechten unteren Kante.

Der Schwingquarz 8 ist in dem unteren Gehäuseteil 3 montiert. In dies Gehäuseteil führen von der einen Seite zwei für die Oberflächenmontage geeignete Anschlußleiter 4a und 4b, die durch eine Glasdurchführung von dem Gehäuse isoliert sind.
An der gegenüberliegenden, niedrigen Seite des unteren Gehäuseteils 3 bildet dieses selbst zwei (oder gegebenenfalls nur einen) Anschlußleiter 5a und 5b, so daß das Gehäuse mit 4 (bzw. 3) Anschlußleitern sicher mit Hilfe der üblichen (automatischen) Verfahren auf einer Printplatte montiert werden kann.

Der Schwingquarz 8 ist über ein Hilfsteil 7 mit den Anschlußleitern 4a und 4b verbunden und erstreckt sich in Richtung des niedrigen Randes des unteren Gehäuseteils 3, so daß selbst bei vollkontaktiertem Gehäuse - solange der obere Gehäuseteil 2 nicht angebracht ist - der Schwingquarz manipuliert werden kann.

Das obere Gehäuseteil 2 wird mit dem unteren Gehäuseteil 3 auf geeignete Weise, z.B. durch Schweißen oder Kleben verbunden. Dies kann unter Umständen erst dann geschehen, wenn der untere Gehäuseteil 3 mit dem Bauelement 8 bereits über seine Anschlußleiter 4 und 5 auf einer Printplatte z.B. durch Löten oder mit Hilfe eines leitenden Klebers befestigt ist.

Die beiden Gehäuseteile 2 und 3 sind vorzugsweise aus Blech tiefgezogen.
Sie bilden zusammen vorzugsweise ein schachtel- oder quaderförmiges Gehäuse; das Gehäuse kann jedoch aus dosenförmig gestaltet sein, d.h. in der Draufsicht einen kreisförmigen Querschnitt aufweisen.

Selbstverständlich ist das erfindungsgemäße Gehäuse außer für Schwingquarze auch für andere Bauelemente geeignet, die in einem hermetisch verschlossenen Gehäuse mit für Oberflächenmontage geeigneten Anschlußleitern untergebracht werden sollen.

## Patentansprüche

1. Hermetisch verschlossenes, schachtel- oder dosenförmiges Schwingquarzgehäuse (1) mit für Oberflächenmontage (SMD) geeigneten Anschlußleitern (4,5) aus zwei miteinander verbindbaren Gehäuseteilen (2,3), bei dem Anschlußleiter (4a,4b) isoliert durch ein Gehäuseteil (3) hindurchgeführt und mindestens ein weiterer Anschlußleiter (5a,5b) mit dem Gehäuseteil verbunden ist,
dadurch gekennzeichnet,
daß das Gehäuse (1) in einer gegenüber seiner Grundfläche geneigten Ebene in einen oberen (2) und einen unteren (3), miteinander verbindbares Gehäuseteil geteilt ist, daß die Anschlußleiter (4a,4b) des Schwingquarzes an einer Seite isoliert durch das untere Gehäuseteil (3) geführt sind, mit dem an der gegenüberliegenden Seite mindestens ein weiterer Anschlußleiter (5) verbunden ist und daß der Schwingquarz (8) in dem unteren Gehäuseteil (3) montiert ist.

2. Schwingquarzgehäuse nach Anspruch 1,
dadurch gekennzeichnet,
daß die Ebene das Gehäuse diagonal schneidet.

3. Schwingquarzgehäuse nach Anspruch 1,
dadurch gekennzeichnet,
daß die miteinander verbindbaren Ränder der beiden Gehäuseteile (2,3) als Flansch (9) ausgebildet sind.

4. Schwingquarzgehäuse nach Anspruch 2,
dadurch gekennzeichnet,
daß die Ränder der beiden Gehäuseteile miteinander verschweißt sind.

5. Schwingquarzgehäuse nach Anspruch 1,
dadurch gekennzeichnet,
daß der bzw. die mit dem unteren Gehäuseteil (3) verbundenen Anschlußleiter (5a,5b) als Teile dieses Gehäuseteils ausgebildet sind.

6. Schwingquarzgehäuse nach Anspruch 1,
dadurch gekennzeichnet,
daß das Bauelement (8) so in dem unteren Gehäuseteil (3) montiert ist, daß es sich, vorzugsweise parallel zur Bodenfläche des Gehäuseteils, zu der niedrigsten Seitenkante des Gehäuseteils hin erstreckt.

## Claims

1. A hermetically sealed box-shaped or cylinder-shaped quartz vibrator housing (1) having terminals (4, 5) suitable for surface mounting (SDM) and consisting of two housing portions (2, 3) which can be interconnected, terminals (4a, 4b) being led through a housing portion (3) in an insulated manner and at last one further terminal (5a, 5b) being connected to said housing portion, characterized in that the housing (1) is severed, in a plane which is inclined with respect to its base, into an upper (2) and a lower (3) housing portion which an be interconnected in that the terminals (4a, 4b) of the quartz vibrator, which are insulated on one side, are led through the lower housing portion (3) to which on the opposite side at last one further terminal (5) is connected, and that the quartz vibrator (8) is mounted in the lower portion of the housing (3).

2. A quartz vibrator housing as claimed in Claim 1, characterized in that the plane intersects the housing diagonally.

3. A quartz vibrator housing as claimed in Claim 1, characterized in that the edges of the two housing portions (2, 3) which an be interconnected are constructed as flanges (9).

4. A quartz vibrator housing as claimed in Claim 2, characterized in that the edges of the two housing portions are welded together.

5. A quartz vibrator housing as claimed in Claim 1, characterized in that the terminal(s) (5a, 5b) connected to the lower housing portion (3) is (are) constructed as parts of the housing portion.

6. A quartz vibrator housing as claimed in Claim 1, characterized in that the component (8) is mounted in the lower portion of the housing (3) so as to extend towards the lowest lateral edge of the housing portion, preferably parallel to the base of the housing portion.

## Revendications

1. Boîtier de résonateur piézo-électrique (1) présentant la forme d'une boîte ou d'un cylindre fermé de façon hermétiquement étanche et muni de conducteurs de connexion convenables (4, 5) pour un montage superficiel, constitué de deux parties de boîtier (2, 3) pouvant être reliées mutuellement, des conducteurs de connexion (4a, 4b) passant de façon isolée à travers une partie de boîtier (3) et, au moins, un autre conducteur de connexion (5a, 5b) étant connecté à la partie de boîtier, caractérisé en ce que dans un plan incliné par rapport à sa surface de base, le boîtier (1) est divisé en une partie supérieure (2) et inférieure (3) pouvant être reliées mutuellement, en ce que les conducteurs de courant du composant passent d'un côté, de façon isolée, à travers la partie de boîtier inférieure (3) à laquelle est relié du côté situé à l'opposé, au moins, un autre conducteur de connexion (5) et en ce que le résonateur piézo-électrique (8) est monté dans la partie de boîtier inférieure (3).

2. Boîtier de résonateur piézo-électrique selon la revendication 1, caractérisé en ce que le plan s'étend diagonalement à travers le boîtier.

3. Boîtier de résonateur piézo-électrique selon la revendication 1, caractérisé en ce que les bords des deux parties de boîtier (2, 3) pouvant être reliés mutuellement constituent une collerette (9).

4. Boîtier de résonateur piézo-électrique selon la revendication 2, caractérisé en ce que les bords des deux parties de boîtier sont reliés par soudage.

5. Boîtier de résonateur piézo-électrique selon la revendication 1, caractérisé en ce que le(s) conducteur(s) de connexion (5a, 5b) connecté (s) à la partie de boîtier inférieure (3) est (sont) conçu(s) comme constituant(s) de ladite partie de boîtier.

6. Boîtier de résonateur piézo-électrique selon la revendication 1, caractérisé en ce que le composant (8) est monté dans la partie de boîtier inférieure (3) de manière qu'il s'étend de préférence parallèlement à la surface de fond de la partie de boîtier, dans la direction du côté inférieur de la partie de boîtier.
